(19) Europäisches Patentamt / European Patent Office / Office européen des brevets

(11) **EP 3 333 584 B1**

(12) **EUROPÄISCHE PATENTSCHRIFT**

(45) Veröffentlichungstag und Bekanntmachung des Hinweises auf die Patenterteilung:
**25.05.2022   Patentblatt 2022/21**

(21) Anmeldenummer: **17166231.5**

(22) Anmeldetag: **12.04.2017**

(51) Internationale Patentklassifikation (IPC):
**G01R 33/483** (2006.01)   **G01R 33/561** (2006.01)

(52) Gemeinsame Patentklassifikation (CPC):
**G01R 33/4835; G01R 33/5611**

(54) **OPTIMIERUNG DER GLEICHZEITIGEN ERFASSUNG VON MR-DATEN IN MEHREREN VOLUMENELEMENTEN ODER SCHICHTEN**

OPTIMISATION OF THE SIMULTANEOUS DETECTION OF MR DATA IN MULTIPLE VOLUME ELEMENTS OR SLICES

OPTIMISATION DE LA DÉTECTION SIMULTANÉE DE DONNÉES RM DANS DES PLUSIEURS ÉLÉMENTS DE VOLUME OU DES TRANCHES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**13.06.2018   Patentblatt 2018/24**

(73) Patentinhaber: **Siemens Healthcare GmbH**
**91052 Erlangen (DE)**

(72) Erfinder: **Feiweier, Thorsten**
**91099 Poxdorf (DE)**

(56) Entgegenhaltungen:
- YI WANG ET AL: "Phase-cycled simultaneous multislice balanced SSFP imaging with CAIPIRINHA for efficient banding reduction : Simultaneous Multislice for SSFP Banding Reduction", MAGNETIC RESONANCE IN MEDICINE., Bd. 76, Nr. 6, 15. Dezember 2016 (2016-12-15), Seiten 1764-1774, XP055394494, US ISSN: 0740-3194, DOI: 10.1002/mrm.26076
- D. KENKEL ET AL: "Whole-Body Diffusion Imaging Applying Simultaneous Multi-Slice Excitation", ROFO - FORTSCHRITTE AUF DEM GEBIET DER RONTGENSTRAHLEN UND DER BILDGEBENDEN VERFAHREN, Bd. 188, Nr. 04, 22. März 2016 (2016-03-22), Seiten 381-388, XP055394518, DE ISSN: 1438-9029, DOI: 10.1055/s-0035-1567032
- XU JUNQIAN ET AL: "Evaluation of slice accelerations using multiband echo planar imaging at 3T", NEUROIMAGE, vol. 83, 27 July 2013 (2013-07-27), pages 991-1001, XP028758328, ISSN: 1053-8119, DOI: 10.1016/J.NEUROIMAGE.2013.07.055

**Beschreibung**

Die vorliegende Erfindung betrifft Optimierungen im Zusammenhang mit dem gleichzeitigen Erfassen von MR-Daten in mehreren Volumenelementen (Slabs oder Schichten).

Der Wunsch nach immer schnelleren MR-Aufnahmen im klinischen Umfeld führt zu einer Renaissance von Verfahren, bei welchen mehrere Bilder (genauer gesagt MR-Daten in mehreren Slabs oder Schichten) simultan aufgenommen werden. Allgemein lassen sich diese Verfahren dadurch charakterisieren, dass zumindest während eines Teils der Messung (des Schritts der MR-Daten-Erfassung) gezielt eine Transversalmagnetisierung von zumindest zwei Slabs oder Schichten gleichzeitig für den Bildgebungsprozess genutzt wird. Diese Verfahren sind auch als Multi-Schicht-Bildgebung oder Schicht-Multiplexing bekannt und werden häufig auch als simultane Mehrschichtbildgebung (SMS) bezeichnet.

Im Gegensatz zu Multi-Schicht-Bildgebung oder Schicht-Multiplexing wird bei der etablierten Mehrschicht-Bildgebung das Signal (die MR-Daten) von mehreren Slabs bzw. Schichten alternierend (nicht gleichzeitig), d.h. vollständig unabhängig voneinander mit entsprechend längerer Messzeit, aufgenommen.

In der Regel wird die simultane Mehrschichtbildgebung eingesetzt, um

a) eine vorgegebene Anzahl von Schichten oder Slabs in kürzerer Zeit (d.h. mit kürzerer Repetitionszeit TR), oder

b) um eine größere Anzahl von Schichten oder Slabs in vergleichbarer Zeit (d.h. mit ähnlicher Repetitionszeit TR)

aufzunehmen. Wenn die simultane Mehrschichtbildgebung für die Reduktion von Aufnahmezeiten verwendet wird (Option a), ist zu beachten, dass eine Verkürzung der Repetitionszeit TR unerwünschte Einflüsse auf den Bildkontrast haben kann. Beispielsweise darf weder bei T2-gewichteter noch bei nach Protonendichte gewichteter Bildgebung die Repetitionszeit TR zu kurz gewählt werden, da sonst Gewebe mit langen T1-Relaxationszeiten nicht adäquat dargestellt wird. Typischerweise wird daher die Repetitionszeit TR nicht viel kürzer als die maximale für das Bild relevante longitudinale Relaxationszeit T1 gewählt.

Aufgrund dieser Randbedingungen sind die potentiellen Vorteile der bekannten simultanen Mehrschichtbildgebung beispielsweise bei der echoplanaren Diffusionsbildgebung oder bei der funktionellen Bildgebung mit EPI ("Echo Planar Imaging") z.B. beim Einsatz von Turbo-Spin-Echo-Sequenzen erheblich eingeschränkt.

Simultane Multischicht-Verfahren sind beispielsweise in dem Artikel von Wang et al. "Phase-cycled simultaneous multislice balanced SSFP imaging with CAIPIRINHA for efficient banding reduction : Simultaneous Multislice for SSFP Banding Reduction", Magn. Reason. Med 76: S.1764-1774 (2016), dem Artikel von Kenkel et al. "Whole-Body Diffusion Imaging Applying Simultaneous Multi-Slice Excitation", ROFO - Fortschritte auf dem Gebiet der Röntgenstrahlen und der bildgebenden Verfahren ,Bd. 188, Seiten 381-388 (2016), oder auch dem Artikel von Xu et al. "Evaluation of slice accelerations using multiband echo planar imaging at 3T", Neuroimage, Bd. 83: Seiten 991-1001 (2013), beschrieben.

Die vorliegende Erfindung stellt sich die Aufgabe, eine simultane Mehrschichtbildgebung bereitzustellen, bei welcher bei den zuletzt genannten Anwendungsfällen das Rauschniveau verbessert wird, ohne dabei den Kontrast zu verschlechtern.

Erfindungsgemäß wird diese Aufgabe durch ein Verfahren zum Erfassen von MR-Daten nach Anspruch 1, durch eine Magnetresonanzanlage nach Anspruch 11, durch ein Computerprogrammprodukt nach Anspruch 12 und durch einen elektronisch lesbaren Datenträger nach Anspruch 13 gelöst. Die abhängigen Ansprüche definieren bevorzugte und vorteilhafte Ausführungsformen der vorliegenden Erfindung.

Im Rahmen der vorliegenden Erfindung wird ein Verfahren zum Erfassen von MR-Daten eines Volumenabschnitts eines Untersuchungsobjekts mittels einer Magnetresonanzanlage bereitgestellt. Das erfindungsgemäße Verfahren umfasst folgende Schritte:

- Vorgeben einer Menge von mehreren geplanten Volumenelementen innerhalb des Volumenabschnitts. Dabei sollen von jedem der geplanten Volumenelemente MR-Daten erfasst werden. Bei jedem der geplanten Volumenelemente kann es sich dabei um ein dreidimensionales Volumenelement (einen sogenannten Slab) oder um ein zweidimensionales Volumenelement (eine Schicht) handeln. Beim Erfassen der MR-Daten für eine Schicht unterscheiden sich die Messpunkte nur in zwei Dimensionen, d.h. entlang der Schichtdickenrichtung existiert nur ein Messpunkt. Dagegen werden beim Erfassen der MR-Daten für einen Slab die Messpunkte in allen drei Raumrichtungen bzw. Dimensionen erfasst, so dass auch entlang der Dickenrichtung des Volumenelements bzw. Slabs mehrere Messpunkte existieren können. Mit anderen Worten erfolgt das Erfassen der MR-Daten für einen Slab auch mit einer Phasenkodierung in der Dickenrichtung des Slabs.

- Vorgeben von Bedingungen, welche beim Erfassen der MR-Daten der geplanten Volumenelemente einzuhalten sind. Diese Bedingungen umfassen die Anzahl der geplanten Volumenelemente, die Repetitionszeit, die Messzeit pro Volumenelement und den SMS-Faktor (d.h. die Anzahl der gleichzeitig zu erfassenden Volumenelemente), wie es im Folgenden noch genauer erläutert wird. Hierbei beginnt eine Messzeit pro Volumenelement für ein Volumenelement, wenn MR-Daten dieses Volumenelements erfasst werden, und endet für dieses Volumenelement, wenn keine MR-Daten mehr für dieses Volumenelement, aber MR-Daten eines anderen Volumenelements, oder wenn überhaupt keine MR-Daten mehr erfasst werden.

- Bestimmen einer Menge von Zusatz-Volumenelementen (d.h. Zusatz-Slabs oder Zusatzschichten) in Abhängigkeit von den geplanten Volumenelementen und den Bedingungen. In diesem Schritt wird zumindest ein Zusatz-Slab oder eine Zusatzschicht, in der Regel aber mehrere Zusatz-Slabs oder Zusatzschichten bestimmt.

- Erfassen der MR-Daten, wobei MR-Daten von zumindest zwei Volumenelementen gleichzeitig erfasst werden. Dabei handelt es sich bei mindestens einem dieser zumindest zwei Volumenelemente um ein geplantes Volumenelement (d.h. um ein Volumenelement aus der Menge der geplanten Volumenelemente) und bei mindestens einem anderen dieser zumindest zwei Volumenelemente um ein Zusatz-Volumenelement (d.h. um ein Volumenelement aus der Menge der Zusatz-Volumenelemente). Mit anderen Worten werden erfindungsgemäß die MR-Daten zumindest eines geplanten Volumenelements gleichzeitig mit den MR-Daten zumindest eines Zusatz-Volumenelements erfasst. In diesem Schritt können allerdings auch gleichzeitig die MR-Daten mehrerer geplanter Volumenelemente erfasst werden, ohne dass zur gleichen Zeit auch die MR-Daten eines Zusatz-Volumenelements erfasst werden. Insbesondere werden in diesem Schritt die MR-Daten aller geplanten Volumenelemente erfasst.

Es sei nochmals darauf hingewiesen, dass die vorliegende Erfindung zwei Varianten aufweist. Bei der ersten Variante handelt es sich bei den geplanten Volumenelementen um geplante Slabs und bei den Zusatz-Volumenelementen um Zusatz-Slabs. D.h. sowohl bei den geplanten Volumenelementen als auch bei den Zusatz-Volumenelementen handelt es sich um dreidimensionale Volumenelemente. Bei der zweiten Variante handelt es sich dagegen sowohl bei den geplanten Volumenelementen als auch bei den Zusatz-Volumenelementen jeweils um Schichten bzw. zweidimensionale Volumenelemente (d.h. um geplante Schichten und Zusatzschichten).

Wie später noch im Detail erläutert werden wird, tritt bei der nach dem Stand der Technik üblichen simultanen Mehrschichtbildgebung häufig der Fall auf, dass nach einer Abarbeitung aller geplanten Volumenelemente gewartet werden muss, um die Repetitionszeit TR einzuhalten. Erfindungsgemäß wird in einer solchen Situation vorteilhafterweise die Anzahl der Volumenelemente, für die MR-Daten erfasst werden, durch die Hinzunahme der Zusatz-Volumenelemente erhöht. Dadurch kann vorteilhafterweise der Abstand der jeweils gleichzeitig zu erfassenden Volumenelemente erhöht werden, wodurch die Signaltrennung (zwischen den gleichzeitig erfassten Volumenelementen) verbessert und damit das Rauschen reduziert werden kann. Dadurch lassen sich in klinischen Messprotokollen beispielsweise die Anzahl der Mittelungen oder eine Überabtastung in einer der Phasenkodierrichtungen reduzieren, wodurch wiederum die Gesamtmesszeit reduziert werden kann, wobei das ursprüngliche Signal-Rausch-Verhältnis beibehalten wird.

Das gleichzeitige Erfassen der MR-Daten von mehreren Schichten kann dabei erfindungsgemäß mit einem der folgenden Verfahren durchgeführt werden:

- Der Hadamard-Kodierung (z. B. Souza et al., J. CAT 12:1026 (1988)): Zwei (oder mehr) Schichten werden gleichzeitig angeregt, durch entsprechende Ausgestaltung der HF-Anregungspulse wird jeder Schicht eine definierte Signalphase aufgeprägt. Das Signal der Magnetisierung aus beiden Schichten wird zeitgleich empfangen. Eine gleichartige zweite Anregung beider Schichten wird durchgeführt, allerdings mit geänderter relativer Signalphase in den Schichten. Der übrige Bildgebungsprozess (Phasenkodierungsschritte) erfolgt wie gewohnt, das Verfahren ist kombinierbar mit beliebigen Aufnahmetechniken ((Multi-)Gradienten-Echo, (Multi-)Spin-Echo etc.). Mittels geeigneter Rechenoperationen lassen sich aus den beiden Aufnahmen die Signalinformationen beider Schichten separieren.

- Simultane Echo-Refokussierung (SER, SIR, z.B. Feinberg et al., MRM 48:1 (2002)): Zwei (oder mehr) Schichten werden kurz nacheinander angeregt, jeder Schicht wird durch geeignete Gradientenpulse eine definierte räumliche Dephasierung aufgeprägt. Das Signal der Magnetisierung aus beiden Schichten wird mittels geeigneter Gradientenschaltungen in einem kurzen zeitlichen Abstand empfangen. Der übrige Bildgebungsprozess (Phasenkodierungsschritte) erfolgt wie gewohnt, das Verfahren ist kombinierbar mit beliebigen Aufnahmetechniken ((Multi-)Gradienten-Echo, (Multi-)Spin-Echo, etc.). Aus den separat aufgenommenen Daten lassen sich Bilder beider Schichten wie gewohnt generieren.

- Breitband-Datenaufnahme (z.B. Wu et al., Proc. ISMRM 2009:2768): Zwei (oder mehr) Schichten werden gleichzeitig angeregt. Das Signal der Magnetisierung aus beiden Schichten wird zeitgleich empfangen. Während des Datenempfangs ist ein Gradient entlang der Schichtnormalen zugeschaltet, der zu einer Separation der Signale beider Schichten im Frequenzraum führt. Der übrige Bildgebungsprozess (Phasenkodierungsschritte) erfolgt wie gewohnt, das Verfahren ist kombinierbar mit beliebigen Aufnahmetechniken ((Multi-)Gradienten-Echo, (Multi-)Spin-Echo, etc.). Mittels geeigneter Filterung lassen sich aus den simultan aufgenommenen Daten die Signale der beiden Schichten separieren.

* Parallele Bildgebung in Schicht-Richtung (z. B. Larkman et al. JMRI 13:313 (2001)): Zwei (oder mehr) Schichten werden gleichzeitig angeregt. Das Signal der Magnetisierung aus beiden Schichten wird zeitgleich mit zumindest zwei (oder mehr) Spulenelementen empfangen. Der übrige Bildgebungsprozess (Phasenkodierungsschritte) erfolgt wie gewohnt, das Verfahren ist kombinierbar mit beliebigen Aufnahmetechniken ((Multi-)Gradienten-Echo, (Multi-)Spin-Echo, etc.). Eine zusätzliche Kalibrierungsmessung zur Ermittlung der räumlichen Empfangscharakteristik der Spulenelemente wird durchgeführt. Mittels geeigneter Rechenoperationen (z. B. GRAPPA-Algorithmus) lassen sich aus den simultan aufgenommenen Daten die Signale der beiden Schichten separieren.

Erfindungsgemäß ist es dabei möglich, nur die geplanten Volumenelemente vollständig zu prozessieren und somit nur für die geplanten Volumenelemente jeweils MR-Bilder zu rekonstruieren und die Zusatz-Volumenelemente nicht vollständig zu prozessieren, so dass für die Zusatz-Volumenelemente keine MR-Bilder rekonstruiert werden. Bei dieser Ausführungsform ist es sogar denkbar, die für die Zusatz-Volumenelemente erfassten MR-Daten nicht zu speichern, sondern zu verwerfen.

Es ist allerdings auch möglich, sowohl die geplanten Volumenelemente als auch die Zusatz-Volumenelemente vollständig zu prozessieren, so dass MR-Bilder sowohl für die geplanten Volumenelemente als auch für die Zusatz-Volumenelemente rekonstruiert werden. Dazu ist es beispielsweise möglich, dem Benutzer eine Option anzubieten, ob die Zusatz-Volumenelemente prozessiert werden sollen oder nicht (ob also MR-Bilder auch für die Zusatz-Volumenelemente rekonstruiert werden sollen oder nicht).

Erfindungsgemäß findet somit eine gemeinsame Prozessierung aller Volumenelemente (d.h. der geplanten Volumenelemente und der Zusatz-Volumenelemente) bis zu dem Schritt der Signaltrennung der gleichzeitig angeregten Volumenelemente statt. Ab diesem Schritt liegen die MR-Daten der gleichzeitig angeregten Volumenelemente in getrennter Form vor, so dass ab diesem Schritt die MR-Daten der Zusatz-Volumenelemente verworfen und nur die MR-Daten der vom Benutzer geplanten Volumenelemente weiterverarbeitet werden können. Dadurch können beispielsweise dem Radiologen nur die vollständig verarbeiteten und gespeicherten MR-Bilder für die geplanten Volumenelemente zur Befundung angezeigt werden.

Wie bereits vorab beschrieben worden ist, umfassen die Bedingungen die Anzahl der geplanten Volumenelemente, die Repetitionszeit TR, die Messzeit pro Volumenelement und den SMS-Faktor. Die Messzeit für ein bestimmtes Volumenelement definiert dabei die Zeitspanne, in welcher fortlaufend (ohne Unterbrechung) MR-Daten für das bestimmte Volumenelement erfasst werden. Dabei umfasst die Messzeit auch die zur eigentlich Aufnahme der MR-Daten erforderlichen Vorbereitungen, wie Anregung, Spoiling, Phasenkodierung, Rephasierung usw. Mit anderen Worten definiert die Messzeit die Zeitspanne für die Ausführung eines Aufnahmemoduls eines Volumenelements. Wenn die Summenmesszeit für das bestimmte Volumenelement die Zeitspanne definiert, während welcher alle MR-Daten für das bestimmte Volumenelement erfasst werden, dann kann die Summenmesszeit durch das Produkt aus der Messzeit und der Anzahl der Durchläufe, während welchen kontinuierlich bzw. fortlaufend MR-Daten für das bestimmte Volumenelement erfasst werden, berechnet werden. Die Gesamtmesszeit für alle Volumenelemente ist dann noch einmal deutlich größer als die Summenmesszeit, da noch die Wartezeiten berücksichtigt werden müssen, während denen keine MR-Daten für das jeweilige Volumenelement erfasst werden. Die Gesamtmesszeit entspricht in der Regel dem Produkt aus der Anzahl der Durchläufe und der Repetitionszeit TR.

Gemäß einer bevorzugten erfindungsgemäßen Ausführungsform wird vor dem Erfassen der MR-Daten überprüft, ob der SMS-Faktor abhängig von der Anzahl der geplanten Volumenelemente $\#_{pS}$ verkleinert werden kann. Dazu wird überprüft, ob folgende Ungleichung (1) gilt:

$$TR \geq \frac{\#_{pS}}{(SMS-1)} \cdot T \qquad (1),$$

Wenn die Ungleichung (1) gilt, wird der SMS-Faktor SMS dekrementiert, wobei dann wiederum überprüft wird, ob die Ungleichung (1) für den dekrementierten SMS-Faktor SMS immer noch gilt. Wenn dies wiederum der Fall ist, wird der SMS-Faktor SMS wiederum dekrementiert, was so lange fortgeführt wird, bis entweder die Ungleichung (1) nicht mehr gilt oder bis der SMS-Faktor den Wert 1 aufweist. Erfindungsgemäß wird die Erfassung der MR-Daten dann mit dem ursprünglichen SMS-Faktor SMS durchgeführt, wenn die Ungleichung (1) bereits für diesen ursprünglichen SMS-Faktor SMS nicht galt, oder die Erfassung der MR-Daten wird mit dem entsprechend oft dekrementierten SMS-Faktor SMS durchgeführt. Mit anderen Worten wird die Anzahl der Zusatz-Volumenelemente abhängig von dem finalen SMS-Faktor bestimmt, mit dem auch die Erfassung der MR-Daten durchgeführt wird, wie es vorab beschrieben ist.

Der vom Benutzer im Messprotokoll definiert SMS-Faktor gibt somit quasi nur eine erlaubte Obergrenze an, die erfindungsgemäß optimiert (d.h. reduziert) werden kann.

Dabei wird die folgende Ungleichung (2) erfüllt.

$$\frac{N}{SMS} \cdot T \leq TR - T \qquad (2)$$

Dabei entspricht N der Anzahl der geplanten Volumenelemente, SMS dem SMS-Faktor, T der Messzeit pro Volumenelement und TR der vorgegebenen Repetitionszeit.

Nur wenn obige Ungleichung (2) erfüllt ist, ist ausreichend Zeit vorhanden, um zusätzlich zu den MR-Daten für die geplanten Volumenelemente MR-Daten für zumindest ein Zusatz-Volumenelement aufzunehmen.

Die Anzahl der Zusatz-Volumenelemente wird ausgehend von der Anzahl aller Volumenelemente, für welche MR-Daten erfasst werden, berechnet, indem von dieser Anzahl aller Volumenelemente die Anzahl der geplanten Volumenelemente abgezogen wird. Die Anzahl aller Volumenelemente $\#_S$ wird anhand der folgenden Gleichung (3) bestimmt:

$$\#_S = SMS \cdot floor\left(\frac{TR}{T}\right) \qquad (3).$$

Dabei entspricht SMS dem SMS-Faktor, welcher vorgibt, für wie viele Volumenelemente gleichzeitig MR-Daten erfasst werden. Darüber hinaus entspricht TR der Repetitionszeit und T der Messzeit pro Volumenelement.

Die Abrundungsfunktion floor(x), welche auch als Gaußklammer bekannt ist, ordnet dem Funktionsargument x die nächstliegende natürliche Zahl zu, welche nicht größer als das Funktionsargument x ist. Wenn also das Funktionsargument x einer natürlichen Zahl entspricht, entspricht der Funktionswert dem Funktionsargument x.

Im Normalfall werden für alle Zusatz-Volumenelemente MR-Daten erfasst. Es ist allerdings erfindungsgemäß möglich, dass beispielsweise aufgrund physiologischer Limitierungen (z.B. aufgrund von SAR ("Specific Absorption Rate") oder aufgrund von Stimulationen) eine vorbestimmte Grenze für die Anzahl der Zusatz-Volumenelemente zu berücksichtigen ist. Wenn beispielsweise die mit Hilfe der Gleichung (3) berechnete Anzahl der Zusatz-Volumenelemente höher als diese vorbestimmte Grenze liegt, wird die Anzahl der Zusatz-Volumenelemente reduziert, bis diese vorbestimmte Grenze eingehalten wird. Mit anderen Worten wird die Anzahl aller Volumenelemente so oft um den Wert SMS reduziert, bis entweder die vorbestimmte Grenze eingehalten wird oder bis (im Extremfall) die Anzahl aller Volumenelemente $\#_S = 0$ gilt.

Dadurch wird vorteilhafterweise dafür gesorgt, dass die vorliegende Erfindung die vorgeschriebenen physiologischen Limitierungen einhält.

Gemäß einer erfindungsgemäßen Ausführungsform umfasst der Schritt des Erfassens der MR-Daten eine Justage-Optimierung. Dabei wird die Justage-Optimierung in einem größeren Umfang anhand der räumlichen Position des jeweils geplanten Volumenelements als anhand der räumlichen Position des jeweiligen Zusatz-Volumenelements ausgerichtet.

Da die MR-Daten der Zusatz-Volumenelemente unter Umständen sogar verworfen werden, ist es sinnvoller, die Justage-Optimierung bei einem Erfassen von MR-Daten, bei welchem gleichzeitig MR-Daten eines geplanten Volumenelements und eines Zusatz-Volumenelements erfasst werden, an der Position des geplanten Volumenelements auszurichten.

Die Justage-Optimierung kann dabei zumindest einen Vorgang aus der folgenden Gruppe von Vorgängen umfassen:

- Die Optimierung der Mittenfrequenz. Mit Kenntnis der räumlichen B0-Feldverteilung kann für jedes der simultan aufgenommenen Volumenelemente eine optimale mittlere Präzessionsfrequenz bestimmt werden. Dem entsprechenden Aufnahmemodul kann beispielsweise ein gewichteter Mittelwert der Frequenzen zugewiesen werden. Dabei kann die Wichtung der den Zusatz-Volumenelementen zugeordneten mittleren Frequenzen kleiner gewählt werden, um so beispielsweise Limitierungen in der Sende-Bandbreite zu begegnen.

- Die Optimierung von Shim-Strömen. Mit Kenntnis der räumlichen B0-Feldverteilung kann für jedes der simultan aufgenommenen Volumenelemente eine optimale Einstellung von Shim-Strömen zur Feldhomogenisierung bestimmt werden. Dem entsprechenden Aufnahmemodul kann beispielsweise ein gewichteter Mittelwert zugewiesen werden. Dabei kann die Wichtung der den Zusatz-Volumenelementen zugeordneten Shim-Strömen kleiner gewählt werden, um so in den geplanten Volumenelementen eine bessere Feldhomogenität zu erreichen als in den Zusatz-Volumenelementen.

- Die Optimierung einer Transmitterskalierung. Mit Kenntnis der räumlichen B1-Feldverteilung kann für jedes der simultan aufgenommenen Volumenelemente eine optimale mittlere Transmitterskalierung bestimmt werden. Dem entsprechenden Aufnahmemodul kann beispielsweise ein gewichteter Mittelwert zugewiesen werden. Dabei kann die Wichtung der den Zusatz-Volumenelementen zugeordneten Transmitterskalierungen kleiner gewählt werden, um so in den geplanten Volumenelementen eine bessere Flipwinkeltreue zu erreichen als in den Zusatz-Volumenelementen.

Sofern simultane Anregungspulse mit individueller Transmitterskalierung jedes Teilpulses verwendet werden, kann den Zusatzschichten auch eine (im Extremfall auf null) reduzierte Skalierung zugewiesen werden, was unmittelbar zu kleinerem SAR führt. (Mit der Skalierung auf null erreicht man im Prinzip einen Mischbetrieb mit unterschiedlichen SMS-Faktoren.)

- Die Optimierung eines Mehrkanal-Transmitters. Mit Kenntnis der räumlichen B1-Feldverteilung kann für jedes der simultan aufgenommenen Volumenelemente eine optimale Einstellung der Stromverteilung (Amplitude und Phase) in den einzelnen Sendekanälen bestimmt werden. Dem entsprechenden Aufnahmemodul kann beispielsweise ein gewichteter Mittelwert zugewiesen werden.

- Die Optimierung einer Wirbelstromkompensation. Dabei wird die Wirbelstromkompensation so ausgeführt, dass die Wirbelströme innerhalb des jeweils geplanten Volumenelements besser kompensiert werden, als die Wirbelströme innerhalb des jeweiligen Zusatz-Volumenelements.

- Die Optimierung einer Kompensation von Querkomponenten der Gradientenfelder ("Maxwell-Feldterme"). Dabei wird die Maxwell-Kompensation so ausgeführt, dass die Effekte von Querkomponenten der Gradientenfelder innerhalb des jeweils geplanten Volumenelements besser kompensiert werden, als diejenigen von Querkomponenten innerhalb des jeweiligen Zusatz-Volumenelements.

- Die Optimierung einer Nichtlinearitätskorrektur der Gradientenfelder. Dabei wird die Nichtlinearitätskorrektur so ausgeführt, dass die Nichtlinearitäten innerhalb des jeweils geplanten Volumenelements besser kompensiert werden, als innerhalb des jeweiligen Zusatz-Volumenelements.

In der Regel ist der Abstand zwischen benachbarten geplanten Volumenelementen konstant. Dieser Abstand entspricht insbesondere auch dem Abstand zwischen zwei benachbarten Zusatz-Volumenelementen und auch dem Abstand zwischen einem Zusatz-Volumenelement und einem zu diesem Zusatz-Volumenelement benachbarten geplanten Volumenelement.

Grundsätzlich könnten der Abstand zwischen zwei benachbarten Zusatz-Volumenelementen und der Abstand zwischen einem Zusatz-Volumenelement und einem zu diesem Zusatz-Volumenelement benachbarten geplanten Volumenelement auch größer sein als der Abstand zwischen zwei benachbarten geplanten Volumenelementen. Der Vorteil wäre eine bessere Trennung zwischen den Volumenelementen, d.h. weniger g-Factor-Noise. Allerdings wären die Zusatz-Volumenelemente für den Radiologen schlechter auswertbar, so dass die MR-Daten der Zusatz-Volumenelemente wahrscheinlich verworfen werden würden. Darüber hinaus könnten Auswirkungen auf den Bildkontrast aufgrund von Crosstalk- oder Magnetisierungs-Transfer-Effekten auftreten.

Mit anderen Worten ist der Abstand zwischen zwei benachbarten Volumenelementen des Volumenelement-Stapels, welcher aus den geplanten Volumenelementen und den Zusatz-Volumenelementen besteht, gleich bzw. konstant. Dies gilt unabhängig davon, ob der Abstand zwischen zwei benachbarten geplanten Volumenelementen, zwischen zwei benachbarten Zusatz-Volumenelementen oder zwischen einem geplanten Volumenelement und einem benachbarten Zusatz-Volumenelement liegt.

Wenn man sich die geplanten Volumenelemente als einen Volumenelement-Stapel vorstellt, sind die Zusatz-Volumenelemente vorteilhafterweise zu möglichst gleichen Teilen oberhalb und unterhalb dieses Volumenelement-Stapels angeordnet.

Wenn also beispielsweise n Zusatz-Volumenelemente existieren, dann werden n/2 Zusatz-Volumenelemente vor dem Volumenelement-Stapel aus geplanten Volumenelementen und n/2 Zusatz-Volumenelemente nach diesem Volumenelement-Stapel angeordnet. In der Regel ist die Anzahl der Zusatz-Volumenelemente gerade. Wenn die Anzahl der Zusatz-Volumenelemente ungerade sein sollte, unterscheidet sich die Anzahl der Zusatz-Volumenelemente welche vor diesem Volumenelement-Stapel angeordnet wird, von der Anzahl der Zusatz-Volumenelemente, welche nach diesem Volumenelement-Stapel angeordnet wird, um ein Zusatz-Volumenelement.

Gemäß einer bevorzugten erfindungsgemäßen Ausführungsform bilden die Menge der geplanten Volumenelemente und die Menge der Zusatz-Volumenelemente eine Gesamtmenge von Volumenelementen. Beim Erfassen der MR-Daten wird dabei ein Durchlauf zumindest einmal, in der Regel aber mehrmals, ausgeführt. In jedem dieser Durchläufe werden dabei MR-Daten für jedes Volumenelement aus der Gesamtmenge erfasst. Dabei werden jeweils MR-Daten von zumindest zwei Volumenelementen aus der Gesamtmenge gleichzeitig erfasst. Der Abstand zwischen benachbarten Volumenelementen, von denen jeweils gleichzeitig MR-Daten erfasst werden, ist dabei konstant.

Mit anderen Worten erfolgt gemäß dieser Ausführungsform das Erfassen der MR-Daten in der Regel in mehreren Durchläufen. Bei jedem dieser Durchläufe werden MR-Daten von jedem Volumenelement erfasst. Jeder Durchlauf unterteilt sich wiederum in Abschnitte, wobei bei jedem Abschnitt gleichzeitig MR-Daten für mehrere Volumenelemente erfasst werden. Der räumliche Abstand zwischen benachbarten Volumenelementen, von denen gleichzeitig MR-Daten erfasst werden, ist dabei für alle Abschnitte konstant bzw. gleich.

Im Rahmen der vorliegenden Erfindung wird auch eine Magnetresonanzanlage bereitgestellt, welche eine HF-Steuereinheit, eine Gradientensteuereinheit und eine Bildsequenzsteuerung umfasst, die ausgebildet sind, um MR-Daten eines Volumenabschnitts eines Untersuchungsobjekts zu erfassen. Die Magnetresonanzanlage ist ausgestaltet, um MR-Daten von jedem Volumenelement aus einer vorgegebenen Menge von geplanten Volumenelementen in dem Volumenabschnitt zu erfassen, um eine Menge von Zusatz-Volumenelementen außerhalb des Volumenabschnitts abhängig von den geplanten Volumenelementen und von Bedingungen zu bestimmen und um MR-Daten aus zumindest zwei Volumenelementen gleichzeitig zu erfassen. Dabei stammen ein Volumenelement aus der Menge der geplanten Volumenelemente und ein Volumenelement aus der Menge der Zusatz-Volumenelemente, so dass MR-Daten eines geplanten Volumenelements und MR-Daten eines Zusatz-Volumenelements gleichzeitig erfasst werden.

Die Vorteile der erfindungsgemäßen Magnetresonanzanlage entsprechen im Wesentlichen den Vorteilen des erfindungsgemäßen Verfahrens, welche vorab im Detail ausgeführt sind, so dass hier auf eine Wiederholung verzichtet wird.

Des Weiteren beschreibt die vorliegende Erfindung ein Computerprogrammprodukt, insbesondere ein Computerprogramm oder eine Software, welche man in einen Speicher einer programmierbaren Steuerung bzw. einer Recheneinheit einer Magnetresonanzanlage laden kann. Mit diesem Computerprogrammprodukt können alle oder verschiedene vorab beschriebene Ausführungsformen des erfindungsgemäßen Verfahrens ausgeführt werden, wenn das Computerprogrammprodukt in der Steuerung oder Steuereinrichtung der Magnetresonanzanlage läuft. Dabei benötigt das Computerprogrammprodukt eventuell Programmmittel, z.B. Bibliotheken und Hilfsfunktionen, um die entsprechenden Ausführungsformen der Verfahren zu realisieren. Mit anderen Worten soll mit dem auf das Computerprogrammprodukt gerichteten Anspruch insbesondere ein Computerprogramm oder eine Software unter Schutz gestellt werden, mit welcher eine der oben beschriebenen Ausführungsformen des erfindungsgemäßen Verfahrens ausgeführt werden kann bzw. welche diese Ausführungsform ausführt. Dabei kann es sich bei der Software um einen Quellcode (z.B. C++), der noch compiliert (übersetzt) und gebunden oder der nur interpretiert werden muss, oder um einen ausführbaren Softwarecode handeln, der zur Ausführung nur noch in die entsprechende Recheneinheit bzw. Steuereinrichtung zu laden ist.

Schließlich offenbart die vorliegende Erfindung einen elektronisch lesbaren Datenträger, z.B. eine DVD, ein Magnetband, eine Festplatte oder einen USB-Stick, auf welchem elektronisch lesbare Steuerinformationen, insbesondere Software (vgl. oben), gespeichert ist. Wenn diese Steuerinformationen (Software) von dem Datenträger gelesen und in eine Steuereinrichtung bzw. Recheneinheit einer Magnetresonanzanlage gespeichert werden, können alle erfindungsgemäßen Ausführungsformen des vorab beschriebenen Verfahrens durchgeführt werden.

Das Grundprinzip der vorliegenden Erfindung ist, so viele simultane Volumenelemente wie mit einem vorgegebenen Messprotokoll möglich aufzunehmen, aber nur so wenige wie nötig (insbesondere nur die geplanten Volumenelemente) zu speichern und zu verarbeiten. Mit anderen Worten wird für ein vorgegebenes Messprotokoll einer simultanen Mehrvolumenelementaufnahme eine größere Anzahl von Volumenelementen aufgenommen als geplant, ohne dadurch die Aufnahmeparameter zu ändern, wobei nur die geplanten Volumenelemente vollständig verarbeitet werden.

Die vorliegende Erfindung nutzt die Eigenschaft aus, dass durch eine Vergrößerung der Anzahl der zu erfassenden Volumenelemente auch der räumliche Abstand der simultan angeregten Volumenelemente vergrößert wird. Da die Signaltrennung der simultan angeregten Volumenelemente abhängig von den räumlichen Sensitivitätsprofilen der Empfangsspulen ist, gilt, dass die Signaltrennung umso einfacher ist, je größer der Abstand zwischen den simultan angeregten Volumenelementen ist.

Gerade bei günstigeren Systemkonfigurationen mit einer geringeren Dichte von Empfangsspulenelementen wird sich der durch die Zusatz-Volumenelemente vergrößerte Abstand der simultan angeregten Volumenelemente besonders vorteilhaft auf die Verbesserung der Bildqualität auswirken.

Die Erfindung wird nachfolgend unter Bezugnahme auf die beiliegenden Zeichnungen näher erläutert.

Fig. 1 zeigt schematisch eine Magnetresonanzanlage, mit welcher erfindungsgemäß MR-Daten erfasst werden.

In Fig. 2 ist schematisch dargestellt, wie erfindungsgemäß MR-Daten für mehrere Schichten gleichzeitig erfasst werden.

In Fig. 3 ist der Flussplan eines erfindungsgemäßen Verfahrens zum Erfassen von MR-Daten dargestellt.

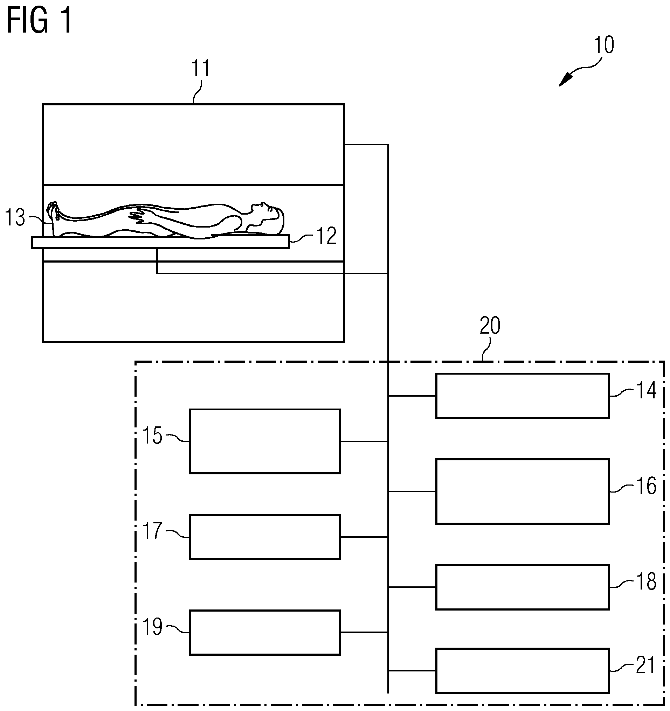

In Bezug auf Fig. 1 wird eine Magnetresonanzanlage 10 erläutert, mit der, wie nachfolgend erläutert wird, gleichzeitig MR-Daten in mehreren Volumenelementen oder Schichten erfasst werden. Die Magnetresonanzanlage 10 weist einen Magneten 11 zur Erzeugung eines Polarisationsfelds B0 auf, wobei eine auf einer Liege 12 angeordnete Untersuchungsperson 13 in den Magneten 11 gefahren wird, um dort ortskodierte Magnetresonanzsignale bzw. MR-Daten aus der Untersuchungsperson 13 aufzunehmen. Die zur Signalaufnahme verwendeten Spulen wie eine Ganzkörperspule oder Lokalspulen sind aus Übersichtlichkeitsgründen nicht dargestellt. Durch Einstrahlen von Hochfrequenzpulsen und Schalten von Magnetfeldgradienten kann die durch das Polarisationsfeld B0 erzeugte Magnetisierung aus der Gleichgewichtslage ausgelenkt und ortskodiert werden, und die sich ergebende Magnetisierung wird von den Empfangsspulen detektiert. Wie durch Einstrahlen der HF-Pulse und durch Schalten von Magnetfeldgradienten in verschiedenen Kombinationen und Reihenfolgen MR-Bilder erzeugt werden können, ist dem Fachmann grundsätzlich bekannt und wird hier nicht näher erläutert.

Die Magnetresonanzanlage 10 weist weiterhin eine Steuereinheit 20 auf, die zur Steuerung der Magnetresonanzanlage 10 verwendet werden kann. Die Steuerung 20 weist eine Gradientensteuereinheit 15 zur Steuerung und Schaltung der notwendigen Magnetfeldgradienten auf. Eine HF-Steuereinheit 14 ist für die Steuerung und Generierung der HF-Pulse zur Auslenkung der Magnetisierung vorgesehen. Eine Bildsequenzsteuerung 16 steuert die Abfolge der Magnetfeldgradienten und HF-Pulse und damit indirekt die Gradientensteuereinheit 15 und die HF-Steuereinheit 14. Über eine Eingabeeinheit 17 kann eine Bedienperson die Magnetresonanzanlage 10 steuern, und auf einer Anzeigeeinheit 18 können MR-Bilder und sonstige zur Steuerung notwendigen Informationen angezeigt werden. Eine Recheneinheit 19 mit mindestens einer Prozessoreinheit (nicht gezeigt) ist vorgesehen zur Steuerung der verschiedenen Einheiten in der Steuereinheit 20. Weiterhin ist eine Speichereinheit 21 vorgesehen, in der beispielsweise Programmmodule bzw. Programme abgespeichert sein können, die, wenn sie von der Recheneinheit 19 bzw. ihrer Prozessoreinheit ausgeführt werden, den Ablauf der Magnetresonanzanlage 10 steuern können. Die Recheneinheit 19 ist ausgebildet, um aus den erfassten MR-Signalen die MR-Bilder zu berechnen.

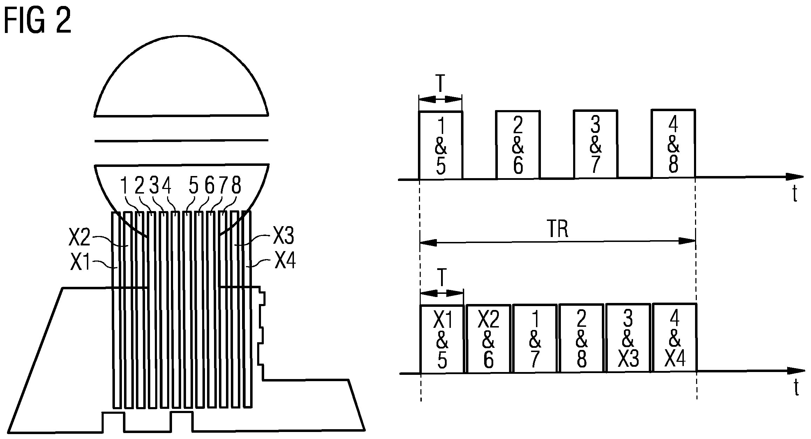

In Fig. 2 ist schematisch dargestellt, wie zum einen nach dem Stand der Technik und zum anderen erfindungsgemäß eine simultane Mehrschichtbildgebung durchgeführt wird.

Im linken Teil der Fig. 2 sind die geplanten Schichten mit dem Bezugszeichen 1 bis 8 bezeichnet. Die geplanten Schichten 1-8 liegen in einem Volumenabschnitt eines Untersuchungsobjekts, von welchem MR-Bilder zu erstellen sind.

Bei einer simultanen Mehrschichtbildgebung nach dem Stand der Technik werden in einem ersten Durchlauf von den Schichten 1 und 5, dann von den Schichten 2 und 6, dann von den Schichten 3 und 7 und schließlich von den Schichten 4 und 8 MR-Daten jeweils gleichzeitig erfasst. Da die vorgegebene minimale Repetitionszeit TR größer ist, als das Produkt aus der Anzahl der geplanten Schichten 8 und der Messzeit T pro Schicht geteilt durch den SMS-Faktor (in diesem Fall 2), existieren Pausen zwischen den einzelnen Messzeiten, während welchen gleichzeitig MR-Daten für zwei Schichten erfasst werden. Das Vorgehen nach dem Stand der Technik ist oben rechts in Fig. 2 dargestellt. Aufgrund dieser wiederholten, kurzen Pausen im Messablauf wird die Magnetresonanzanlage 10 nicht effizient genutzt.

Beispielsweise ergibt sich durch die vorab beschriebene Gleichung (3), dass unter den vorgegebenen Bedingungen (Repetitionszeit TR, Messzeit T und SMS-Faktor) erfindungsgemäß MR-Daten von vier Zusatzschichten zusätzlich zu den acht geplanten Schichten erfasst werden können, ohne dass dazu die Gesamtmesszeit verlängert werden muss. Diese vier Zusatzschichten X1-X4 sind ebenfalls links in der Fig. 2 dargestellt. Dabei liegen zwei dieser Zusatzschichten X1, X2 vor dem Schichtstapel aus geplanten Schichten 1-8 und zwei dieser Zusatzschichten X3, X4 hinter diesem Schichtstapel.

Die erfindungsgemäße Messabfolge der geplanten Schichten 1-8 mit den Zusatzschichten X1-X4 ist in Fig. 2 unten rechts dargestellt. Bei dieser erfindungsgemäßen simultanen Mehrschichtbildgebung werden in dem ersten Durchlauf von den Schichten X1 und 5, dann von den Schichten X2 und 6, dann von den Schichten 1 und 7, dann von den Schichten 2 und 8, dann von den Schichten 3 und X3 und schließlich von den Schichten 4 und X4 jeweils gleichzeitig MR-Daten erfasst.

Vergleicht man die simultane Mehrschichtbildgebung nach dem Stand der Technik mit der erfindungsgemäßen simultanen Mehrschichtbildgebung erkennt man, dass nach dem Stand der Technik der Abstand zwischen denjenigen Schichten, für welche jeweils gleichzeitig MR-Daten erfasst werden, nach dem Stand der Technik bei 4 Schichten liegt, während dieser Abstand erfindungsgemäß bei 6 Schichten liegt. Durch diesen vergrößerten Abstand kann erfindungsgemäß vorteilhafterweise das Rauschniveau verbessert werden, ohne dabei den Kontrast zu verschlechtern. Der erfindungsgemäß größere Abstand erleichtert vorteilhafterweise die Signaltrennung zwischen den gleichzeitig angeregten Schichten. In einem aus den erfindungsgemäß erfassten MR-Daten rekonstruierten MR-Bild äußert sich dieser vergrößerte Abstand vorteilhafterweise zum einen durch eine Verringerung von Schicht-Trennungs-Artefakten ("slice leakage") und zum anderen durch eine Verringerung des sogenannten Beschleunigungsrauschens ("g-factor noise"). Zusammengefasst kann vorteilhafterweise die Bildqualität durch den größeren Abstand verbessert werden.

Im Folgenden soll die vorliegende Erfindung anhand von Beispielen erläutert werden. Dabei werden verschiedene erfindungsgemäße Ausführungsformen insbesondere für eine T2-gewichtete sagittale Turbo-Spin-Echo-Bildgebung der Wirbelsäule beschrieben.

Beispiel 1

Das Beispiel 1 weist folgende Voraussetzungen bzw. Bedingungen auf:

- Die Anzahl der geplanten Schichten beträgt 16, welche für eine vollständige Abdeckung des zu untersuchenden Volumenabschnitts ausreichen.
- Der gewünschte Kontrast erfordert eine minimale Repetitionszeit TR von 3200 ms.
- Die Zeitdauer eines einzelnen Echozuges (TSE-Moduls) und damit die Messzeit T beträgt 250 ms.
- Für ein vollständiges MR-Bild werden 20 Echozüge benötigt.
- Um ein hinreichend großes Signal-Rausch-Verhältnis zu erreichen, werden 5 Mittelungen benötigt.

Bei einer konventionellen Einzelschichtbildgebung würde sich eine reale Repetitionszeit $TR_{real} = 250$ ms * 16 = 4000 ms ergeben, woraus sich dann eine Gesamtmesszeit von 5 * 20 * 4000 ms = 6:40 Minuten ergibt.

Bei einer konventionellen Mehrschichtbildgebung mit einem SMS-Faktor von 2 könnte die Repetitionszeit TR = 250 ms * 16/2 = 2000 ms betragen. Da allerdings die minimale Repetitionszeit TR mit 3200 ms vorgegeben ist, entspricht die reale Repetitionszeit dieser vorgegebenen minimalen Repetitionszeit. Aufgrund des geringen Schichtabstands der gleichzeitig angeregten Schichten erhöht sich nachteiligerweise das Rauschen (g-Faktor), so dass die Zahl der Mittelungen im Vergleich zur konventionellen Einzelschichtbildgebung von 5 auf 6 erhöht werden muss. Als Gesamtmesszeit ergibt sich damit 6 * 20 * 3200 ms = 6:24 Minuten.

Erfindungsgemäß können beispielsweise gemäß Gleichung (3) $\#_S = 2 * floor(3200 \text{ ms} / 250 \text{ ms}) = 2 * 12 = 24$ Schichten insgesamt innerhalb der Repetitionszeit TR gemessen werden. Somit können 8 Zusatzschichten zusätzlich zu den geplanten 16 Schichten gemessen werden. Aufgrund des im Vergleich zur konventionellen Mehrschichtbildgebung (siehe oben) größeren Schichtabstands zwischen den jeweils zwei Schichten, für welche gleichzeitig MR-Daten erfasst werden, verbessert sich die Signaltrennung, wodurch wiederum das Rauschen reduziert wird, so dass 5 Mittelungen ausreichen. Als Gesamtmesszeit ergibt sich damit 5 * 20 * 3200 ms = 5:20 Minuten.

Die für die Zusatzschichten erfassten MR-Daten können dabei verworfen werden, so dass für die Zusatzschichten keine MR-Bilder rekonstruiert werden, so dass der Benutzer nur MR-Bilder für die geplanten Schichten sieht und befunden muss. Es ist erfindungsgemäß natürlich auch möglich, für die Zusatzschichten MR-Bilder zu rekonstruieren, falls dies erwünscht ist.

Beispiel 2

Das Beispiel 2 weist folgende Voraussetzungen bzw. Bedingungen auf:

- Die Anzahl der geplanten Schichten beträgt 10.
- Die minimale Repetitionszeit TR beträgt 2000 ms.
- Die Zeitdauer eines einzelnen Echozuges (TSE-Moduls) und damit die Messzeit T beträgt 200 ms.
- Für ein vollständiges MR-Bild werden 20 Echozüge benötigt.
- Als SMS-Faktor wird 2 vorgegeben.

Da mit der Anzahl der geplanten Schichten von 10, mit der Repetitionszeit TR von 2000 ms, der Messzeit T von 200 ms und dem SMS-Faktor von 2 die oben genannte Ungleichung (1) erfüllt ist, wird der SMS-Faktor dekrementiert. Da der neue bzw. dekrementierte SMS-Faktor 1 beträgt, muss nicht weiter überprüft werden, ob die Ungleichung (1) auch für den neuen SMS-Faktor gilt. Stattdessen werden die 10 geplanten Schichten konventionell, d.h. mit einer Einzelschichtbildgebung, erfasst. Dadurch werden vorteilhafterweise ein zusätzliches Rauschen ("g-Factor-Noise") und Entfaltungsartefakte vermieden.

Beispiel 3

Das Beispiel 3 weist folgende Voraussetzungen bzw. Bedingungen auf:

- Die Anzahl der geplanten Schichten beträgt 12.
- Die minimale Repetitionszeit TR beträgt 2800 ms.
- Die Zeitdauer eines einzelnen Echozuges (TSE-Moduls) und damit die Messzeit T beträgt 400 ms.
- Als SMS-Faktor wird 3 vorgegeben.

Da mit der Anzahl der geplanten Schichten von 12, mit der Repetitionszeit TR von 2800 ms, der Messzeit T von 400 ms und dem SMS-Faktor von 3 die oben genannte Ungleichung (1) erfüllt ist, wird der SMS-Faktor dekrementiert. Da die obige Ungleichung (1) für den neuen SMS-Faktor 2 nicht mehr gilt, werden die MR-Daten mit dem SMS-Faktor 2 erfasst. Da die Anzahl aller Schichten laut der Gleichung (3) gleich 14 ist, werden zusätzlich zu den 12 geplanten Schichten 2 Zusatzschichten erfasst.

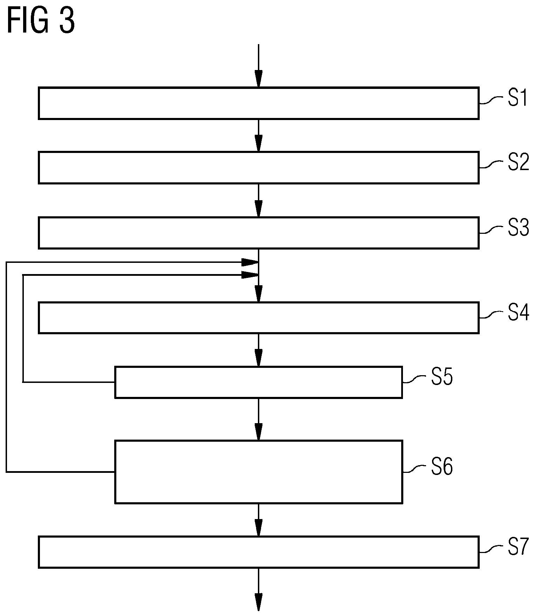

In Fig. 3 ist schematisch der Flussplan für das erfindungsgemäße Verfahren dargestellt.

Im Schritt S1 gibt der Benutzer ein für seine Belange (Kontrast und Schichtabdeckung) optimiertes SMS-Protokoll vor, indem die Anzahl der geplanten Schichten, die Repetitionszeit TR, die Messzeit T und der SMS-Faktor vorgegeben werden. Die Messzeit T wird dabei in der Regel nicht direkt durch den Benutzer vorgegeben, da sich die Messzeit T indirekt beispielsweise über die Auflösung, FOV ("Field of View"), die Messsequenz usw. bestimmen lässt. Anschließend wird im Schritt S2 anhand der vorab beschriebenen Ungleichung (1) überprüft, ob der vorgegebene SMS-Faktor reduziert werden kann. Insbesondere mit der vorab beschriebenen Gleichung (3) werden abhängig von der Repetitionszeit TR, der Messzeit T, der Anzahl der geplanten Schichten und dem eventuell im Schritt S2 reduzierten SMS-Faktor im Schritt S3 Zusatzschichten bestimmt.

Im Schritt S4 werden abhängig von dem SMS-Faktor gleichzeitig MR-Daten mehrerer Schichten erfasst. Dieser Schritt S4 wird so lange wiederholt, bis ein Durchlauf für alle Schichten (geplante Schichten und Zusatzschichten) beendet ist (siehe Abfrage in Schritt S5). Dabei wird beispielsweise bei jedem Durchlauf ein Echozug für alle Schichten abgearbeitet. Wenn die Anzahl der durchgeführten Durchläufe gleich der Anzahl der geplanten Durchläufe ist (siehe Abfrage in Schritt S6), endet das Erfassen der MR-Daten, indem MR-Bilder in der Regel nur für die geplanten Schichten im Schritt S7 rekonstruiert werden. Wenn die Anzahl der durchgeführten Durchläufe noch nicht der Anzahl der geplanten Durchläufe entspricht, springt das erfindungsgemäße Verfahren zurück zum Schritt S4. Die Anzahl der geplanten Durchläufe kann beispielsweise durch das Produkt aus der Anzahl der notwendigen Mittelungen und der Anzahl der pro Schicht zu erfassenden Echozüge bestimmt werden.

**Patentansprüche**

1. Verfahren zum Erfassen von MR-Daten eines Volumenabschnitts eines Untersuchungsobjekts (13) mittels einer Magnetresonanzanlage (10), wobei das Verfahren folgende Schritte umfasst:

   Vorgeben einer Menge von mehreren geplanten Volumenelementen (1-8) in dem Volumenabschnitt, wobei von jedem der geplanten Volumenelemente (1-8) MR-Daten zu erfassen sind, Vorgeben von Bedingungen (TR, T), welche beim Erfassen der MR-Daten der geplanten Volumenelemente (1-8) einzuhalten sind, Bestimmen einer Menge von Zusatz-Volumenelementen (X1-X4) abhängig von den geplanten Volumenelementen (1-8) und den Bedingungen (TR, T), Erfassen der MR-Daten, indem die MR-Daten aus zumindest zwei Volumenelementen (X1, 5; X2, 6; 3, X3; 4, X4) gleichzeitig erfasst werden, wobei die zumindest zwei Volumenelemente ein Volumenelement (3-6) aus der Menge der geplanten Volumenelemente (1-8) und ein Volumenelement (X1-X4) aus der Menge der Zusatz-Volumenelemente (X1-X4) umfassen, **dadurch gekennzeichnet,** **dass** die Bedingungen die Anzahl der geplanten Volumenelemente, die Repetitionszeit (TR), die Messzeit (T) pro Volumenelement (1-8; X1-X4) und einen SMS-Faktor umfassen, wobei die Messzeit (T) pro Volumenelement (1-8; X1-X4) für ein Volumenelement beginnt, wenn MR-Daten dieses Volumenelements erfasst werden, und für dieses Volumenelement endet, wenn keine MR-Daten mehr für dieses Volumenelement, aber MR-Daten eines anderen Volumenelements, oder wenn überhaupt keine MR-Daten mehr erfasst werden, wobei der SMS-Faktor bestimmt, in wie vielen Volumenelementen (1-8, X1-X4) gleichzeitig MR-Daten erfasst werden, und **dass** eine Anzahl der Zusatz-Volumenelemente (X1-X4) durch eine Differenz aus einer Anzahl aller Volumenelemente (1-8, X1-X4) abzüglich der Anzahl der geplanten Volumenelemente (1-8) bestimmt wird, wobei die Repetitionszeit (TR), die Messzeit (T) pro Volumenelement (1-8; X1-X4), der SMS-Faktor und die Anzahl der geplanten Volumenelemente die folgende Ungleichung erfüllen:

$$\frac{N}{SMS} \cdot T \leq TR - T \qquad (2),$$

wobei N der Anzahl der geplanten Volumenelemente entspricht, und

dass die Anzahl $\#_S$ aller Volumenelemente (1-8, X1-X4) anhand folgender Gleichung bestimmt wird,

$$\#_S = SMS \cdot floor\left(\frac{TR}{T}\right) \qquad (3),$$

wobei SMS dem SMS-Faktor, TR der Repetitionszeit und T der Messzeit pro Volumenelement entspricht, wobei $floor\left(\frac{TR}{T}\right)$ die nächstliegende natürliche Zahl ist, welche nicht größer als TR/T ist.

2. Verfahren nach Anspruch 1, **dadurch gekennzeichnet,**

   **dass** jedes geplante Volumenelement eine geplante Schicht (1-8) ist, und **dass** jedes Zusatz-Volumenelement eine Zusatzschicht (X1-X4) ist.

3. Verfahren nach Anspruch 1 oder 2, **dadurch gekennzeichnet,**

   **dass** anhand von den MR-Daten der Zusatz-Volumenelemente (X1-X4) keine MR-Bilder rekonstruiert werden, und **dass** anhand von den MR-Daten der geplanten Volumenelemente (1-8) MR-Bilder rekonstruiert werden.

4. Verfahren nach einem der vorhergehenden Ansprüche, **dadurch gekennzeichnet,** **dass**, wenn die folgende Ungleichung (1) gilt, der SMS-Faktor SMS so lange dekrementiert wird, bis die Ungleichung nicht mehr gilt oder der SMS-Faktor gleich 1 ist,

$$TR \geq \frac{\#_{pS}}{(SMS-1)} \cdot T \qquad (1),$$

wobei TR der Repetitionszeit, $\#_{pS}$ der Anzahl der geplanten Volumenelemente (1-8) und T der Messzeit pro Volumenelement entspricht.

5. Verfahren nach einem der vorhergehenden Ansprüche, **dadurch gekennzeichnet,** **dass** eine vorbestimmte Grenze für die Anzahl der Zusatz-Volumenelemente (X1-X4) berücksichtigt wird.

6. Verfahren nach einem der vorhergehenden Ansprüche, **dadurch gekennzeichnet,**

   **dass** das Erfassen der MR-Daten eine Justage-Optimierung umfasst,
**dass** die Justage-Optimierung mehr anhand der räumlichen Position des geplanten Volumenelements (1-8) als anhand der räumlichen Position des Zusatz-Volumenelements (X1-X4) ausgeführt wird.

**7.** Verfahren nach Anspruch 6,
**dadurch gekennzeichnet,**

**dass** die Justage-Optimierung umfasst
eine Optimierung der Mittenfrequenz,
eine Optimierung von Shim-Strömen,
eine Optimierung der Transmitterskalierung,
eine Optimierung eines Mehrkanal-Transmitters,
eine Optimierung einer Wirbelstromkompensation,
eine Optimierung einer Kompensation von Querkomponenten der Gradientenfelder, und/oder
eine Optimierung einer Nichtlinearitätskorrektur der Gradientenfelder.

**8.** Verfahren nach einem der vorhergehenden Ansprüche, **dadurch gekennzeichnet,**
**dass** ein Abstand, welchen zwei benachbarte geplante Volumenelemente (1-8) aufweisen, gleich einem Abstand ist, welchen zwei benachbarte Zusatz-Volumenelemente (X1-X4) aufweisen, und gleich einem Abstand ist, welchen ein Zusatz-Volumenelement (X2; X3) zu einem benachbarten geplanten Volumenelement (1; 8) aufweist.

**9.** Verfahren nach einem der vorhergehenden Ansprüche, **dadurch gekennzeichnet,**

**dass** die geplanten Volumenelemente (1-8) einen Volumenelement-Stapel bilden,
**dass** die Zusatz-Volumenelemente (X1-X4) in zwei möglichst gleich große Mengen geteilt werden,
**dass** die eine der Mengen (X1, X2) vor dem Volumenelement-Stapel (1-8) und die andere der Mengen (X3, X4) nach dem Volumenelement-Stapel (1-8) angeordnet werden.

**10.** Verfahren nach einem der vorhergehenden Ansprüche, **dadurch gekennzeichnet,**

**dass** die Menge der geplanten Volumenelemente (1-8) und die Menge der Zusatz-Volumenelemente (X1-X4) eine Gesamtmenge von Volumenelementen (1-8, X1-X4) bilden,
**dass** beim Erfassen der MR-Daten ein Durchlauf zumindest einmal ausgeführt wird,
**dass** in dem Durchlauf MR-Daten für jedes Volumenelement aus der Gesamtmenge (1-8, X1-X4) erfasst werden, wobei jeweils MR-Daten aus zumindest zwei Volumenelementen aus der Gesamtmenge (1-8, X1-X4) gleichzeitig erfasst werden, und
**dass** ein Abstand zwischen benachbarten Volumenelementen (X1, 5; X2, 6; 1, 7), von denen jeweils gleichzeitig MR-Daten erfasst werden, konstant ist.

**11.** Magnetresonanzanlage (10), welche eine HF-Steuereinheit (14), eine Gradientensteuereinheit (15) und eine Bildsequenzsteuerung (16) umfasst, die ausgebildet sind, um MR-Daten eines Volumenabschnitts eines Untersuchungsobjekts zu erfassen, wobei die Magnetresonanzanlage (10) ausgestaltet ist,

um MR-Daten von jedem Volumenelement aus einer vorgegebenen Menge von geplanten Volumenelementen (1-8) in dem Volumenabschnitt zu erfassen,
um eine Menge von Zusatz-Volumenelementen (X1-X4) außerhalb des Volumenabschnitts abhängig von den geplanten Volumenelementen (1-8) und von Bedingungen (TR, T) zu bestimmen, und um MR-Daten aus zumindest zwei Volumenelementen (X1, 5; X2, 6; 3, X3; 4, X4) gleichzeitig zu erfassen, die ein Volumenelement (3-6) aus der Menge der geplanten Volumenelemente (1-8) und ein Volumenelement (X1-X4) aus der Menge der Zusatz-Volumenelemente (X1-X4) umfassen, wobei die Magnetresonanzanlage (10) zur Durchführung des Verfahrens nach einem der Ansprüche 1-10 ausgestaltet ist.

**12.** Computerprogrammprodukt, welches ein Programm umfasst und direkt in einen Speicher einer programmierbaren Steuereinrichtung (10) einer Magnetresonanzanlage (5) ladbar ist, mit Programm-Mitteln, um alle Schritte des Verfahrens nach einem der Ansprüche 1-10 auszuführen, wenn das Programm in der Steuereinrichtung (10) der Magnetresonanzanlage (5) ausgeführt wird.

**13.** Elektronisch lesbarer Datenträger mit darauf gespeicherten elektronisch lesbaren Steuerinformationen, welche derart ausgestaltet sind, dass sie bei Verwendung des Datenträgers (21) in einer Steuereinrichtung (10) einer Magnetresonanzanlage (5) das Verfahren nach einem der Ansprüche 1-10 durchführen.

**Claims**

**1.** Method for acquiring MR data of a volume portion of an examination object (13) by means of a magnetic resonance system (10),
wherein the method comprises the following steps:

defining a set of a plurality of planned volume elements (1-8) in the volume portion, wherein MR data is to be acquired from each of the planned volume elements (1-8),
defining conditions (TR, T) which are to be fulfilled on acquisition of the MR data of the planned volume elements (1-8),
determining a set of additional volume elements (X1-X4) dependent upon the planned volume elements (1-8) and the conditions (TR, T),
acquiring the MR data in that the MR data is acquired from at least two volume elements (X1, 5; X2, 6; 3, X3; 4, X4) simultaneously,
wherein the at least two volume elements comprise one volume element (3-6) from the set of the planned volume elements (1-8) and one volume element (X1-X4) from the set of the additional volume elements (X1-X4), **characterised in that** the conditions comprise the number of planned volume elements, the repetition time (TR), the scan time (T) per volume element (1-8; X1-X4) and/or an SMS factor,
wherein the scan time (T) per volume element (1-8; X1-X4) for a volume element begins when the MR data of this volume element is acquired and ends for this volume element when no more MR data is acquired for this volume element, but MR data of another volume element is acquired, or when no more MR data at all is acquired,
wherein the SMS factor determines in how many volume elements (1-8; X1-X4) simultaneously MR data is acquired,
and that a number of the additional volume elements (X1-X4) is determined by a difference from a number of all the volume elements (1-8; X1-X4) less the number of the planned volume elements (1-8),
wherein the repetition time (TR), the scan time (T) per volume element (1-8; X1-X4), the SMS factor and the number of planned volume elements fulfill the following inequality:

$$\frac{N}{SMS} \cdot \ T \leq \ TR - T \qquad (2),$$

wherein N corresponds to the number of planned volume elements, and that the number $\#_S$ of all volume elements (1-8; X1-X4) is determined on the basis of the following equation,

$$\#_S = SMS \cdot \ floor\left(\frac{TR}{T}\right) \qquad (3),$$

wherein SMS corresponds to the SMS factor, TR the repetition time and T the scan time per volume element,

wherein $floor\left(\frac{TR}{T}\right)$ is the nearest natural number that is not greater than TR/T.

2. Method according to claim 1, **characterised in that**

each planned volume element is a planned slice (1-8), and
**in that** each additional volume element is an additional slice (X1-X4).

3. Method according to claim 1 or 2, **characterised in that**

on the basis of the MR data of the additional volume elements (X1-X4), no MR images are reconstructed, and
**in that**, on the basis of the MR data of the planned volume elements (1-8), MR images are reconstructed.

4. Method according to one of the preceding claims, **characterised in that**
if the following inequality (1) applies, the SMS factor SMS is decremented until the inequality no longer applies or the SMS factor is equal to 1,

$$TR \geq \frac{\#_{pS}}{(SMS-1)} \cdot \ T \qquad (1),$$

wherein TR corresponds to the repetition time, $\#_{pS}$ to the number of planned volume elements (1-8) and T to the scan time per volume element.

5. Method according to one of the preceding claims, **characterised in that**
a pre-determined limit for the number of additional volume elements (X1-X4) is taken into account.

6. Method according to one of the preceding claims, **characterised in that**

the acquisition of the MR data comprises an adjustment optimisation,
**in that** the adjustment optimisation is carried out more on the basis of the spatial position of the planned volume element (1-8) than on the basis of the spatial position of the additional volume element (X1-X4).

7. Method according to claim 6, **characterised in that**

the adjustment optimisation comprises an optimisation of the centre frequency,

an optimisation of the shim currents,
an optimisation of the transmitter scaling,
an optimisation of a multichannel transmitter,
an optimisation of an eddy current compensation,
an optimisation of a compensation of transverse components of the gradient fields and/or
an optimisation of a non-linearity correction of the gradient fields.

8.  Method according to one of the preceding claims, **characterised in that**
    a spacing which two adjacent planned volume elements (1-8) have is equal to a spacing that two adjacent additional volume elements (X1-X4) have and is equal to a spacing that an additional volume element (X2; X3) has from an adjacent planned volume element (1; 8).

9.  Method according to one of the preceding claims, **characterised in that**

    the planned volume elements (1-8) form a volume element stack, **in that** the additional volume elements (X1-X4) are divided into two sets as equal as possible in size,
    **in that** one of the sets (X1, X2) is arranged before the volume element stack (1-8) and the other of the sets (X3, X4) is arranged after the volume element stack (1-8).

10. Method according to one of the preceding claims, **characterised in that**

    the set of the planned volume elements (1-8) and the set of the additional volume elements (X1-X4) form a total set of volume elements (1-8; X1-X4),
    **in that** on acquisition of the MR data, a pass is performed at least once,
    **in that** during the pass, MR data for each volume element is acquired from the total set (1-8; X1-X4), wherein in each case MR data is acquired simultaneously from at least two volume elements from the total set (1-8; X1-X4), and
    **in that** a spacing between adjacent volume elements (X1, 5; X2, 6; 1, 7) from which MR data is acquired in each case simultaneously is constant.

11. Magnetic resonance system (10) which comprises an HF control unit (14), a gradient control unit (15) and an image sequence control (16), which are configured to acquire MR data of a volume portion of an examination object,

    wherein the magnetic resonance system (10) is configured in order to acquire MR data from each volume element of a predefined set of planned volume elements (1-8) in the volume portion,
    in order to determine a set of additional volume elements (X1-X4) outside the volume portion dependent upon the planned volume elements (1-8) and the conditions (TR, T), and
    in order to acquire MR data from at least two volume elements (X1, 5; X2, 6; 3, X3; 4, X4) simultaneously, comprising one volume element (3-6) from the set of the planned volume elements (1-8) and one volume element (X1-X4) from the set of the additional volume elements (X1-X4), wherein the magnetic resonance system (10) is configured to carry out the method according to one of claims 1-10.

12. Computer program product which comprises a program and is directly loadable into a memory store of a programmable control system (10) of a magnetic resonance system (5), having program means in order to carry out all the steps of the method according to one of claims 1-10 when the program is executed in the control device (10) of the magnetic resonance system (5).

13. Electronically readable data carrier with items of electronically readable control information stored thereon, which are configured in order, on use of the data carrier (21) in a control device (10) of a magnetic resonance system (5), to carry out the method according to one of claims 1-10.

**Revendications**

1.  Procédé de saisie de données RM d'une partie en volume d'un objet (13) à examiner au moyen d'une installation (10) de résonnance magnétique,
    dans lequel le procédé comprend les stades suivant :

    on se donne à l'avance un ensemble de plusieurs éléments (1 à 8) de volume envisagés dans la partie en volume, des données RM devant être saisies de chacun des éléments (1 à 8) de volume envisagés,
    on se donné à l'avance des conditions (TR, T) à observer à la saisie des données RM des éléments (1 à 8) de volume envisagés,
    on détermine un ensemble d'éléments (X1 à X4) de volume supplémentaires en fonction des éléments (1 à 8) de volume envisagés et des conditions (TR, T),
    on saisit des données RM, en saisissant simultanément les données RM dans au moins deux éléments (X1, 5 ; X2, 6 ; 3, X3 : 4, X4) de volume,
    dans lequel les au moins deux éléments de volume comprennent un élément (3 à 6) de volume de l'ensemble des éléments (1 à 8) de volume envisagés et un élément (X1 à X4) de volume de l'ensemble des éléments (X1 à X4) de volume supplémentaires, **caractérisé**

**en ce que** les conditions comprennent le nombre des éléments de volume envisagés, le temps (TR) de répétition, le temps (T) de mesure par élément (1 à 8 ; X1 à X4) de volume et un facteur SMS,

dans lequel le temps (T) de mesure par élément (1 à 8 ; X1 à X4) de volume, pour un élément de volume, débute lorsque l'on saisit des données RM de cet élément de volume et se termine, pour cet élément de volume, lorsque l'on ne saisit plus de données RM pour cet élément de volume, mais on saisit des données RM d'un autre élément de volume ou lorsque l'on ne saisit absolument plus de données RM,

dans lequel le facteur SMS détermine dans combien d'éléments (1 à 8 ; X1 à X4) de volume, on saisit en même temps des données RM,

et **en ce que** l'on détermine un nombre des éléments (X1 à X4) de volume supplémentaires en soustrayant du nombre de tous les éléments (1 à 8 ; X1 à X4) de volume le nombre des éléments (1 à 8) de volume envisagés,

dans lequel le temps (TR) de répétition, le temps (T) de mesure par éléments (1 à 8 ; X1 à X4) de volume, le facteur SMS et le nombre des éléments de volume envisagés satisfont l'inéquation suivante :

$$\frac{N}{SMS} \cdot T \leq TR - T \qquad (2),$$

dans laquelle N correspond au nombre des éléments de volume envisagés et

**en ce que** l'on détermine le nombre $\#_S$ de tous les éléments (1 à 8 ; X1 à X4) de volume à l'aide de l'équation suivante,

$$\#_S = SMS \cdot floor\left(\frac{TR}{T}\right) \qquad (3),$$

dans laquelle SMS correspond au facteur SMS, TR au temps de répétition et T au temps de mesure par élément de volume,

dans laquelle $floor\left(\frac{TR}{T}\right)$ est le nombre naturel le plus proche, qui n'est pas plus grand que TR/T.

2. Procédé suivant la revendication 1,
**caractérisé**

   **en ce que** chaque élément de volume envisagé est une tranche (1 à 8) envisagée, et

**en ce que** chaque élément de volume supplémentaire est une tranche (X1 à X4) supplémentaire.

3. Procédé suivant la revendication 1 ou 2,
**caractérisé**

   **en ce que** l'on ne reconstruit pas d'image RM à l'aide de données RM des éléments (X1 à X4) de volume supplémentaires, et
   **en ce que** l'on reconstruit des images RM à l'aide des données RM des éléments (1 à 8) de volume envisagés.

4. Procédé suivant l'une des revendications précédentes, **caractérisé**
   **en ce que**, si l'inéquation (1) suivante est vérifiée, on décrémente le facteur SMS, jusqu'à ce que l'inéquation ne soit plus vérifiée ou jusqu'à ce que le facteur SMS soit égal à 1,

$$TR \geq \frac{\#_{pS}}{(SMS-1)} \cdot T \qquad (1),$$

   dans laquelle TR correspond au temps de répétition, $\#_{pS}$ au nombre des éléments (1 à 8) de volume envisagés et T au temps de mesure par élément de volume.

5. Procédé suivant l'une des revendications précédentes, **caractérisé**
   **en ce que** l'on prend en compte une limite définie à l'avance du nombre des éléments (X1 à X4) de volume supplémentaires.

6. Procédé suivant l'une des revendications précédentes, **caractérisé**

   **en ce que** la saisie des données RM comprend une optimisation d'ajustage,
   **en ce que** l'on effectue l'optimisation d'ajustage plus à l'aide de la position dans l'espace des éléments (1 à 8) envisagés qu'à l'aide de la position dans l'espace des éléments (X1 à X4) de volume supplémentaires.

7. Procédé suivant la revendication 6,
**caractérisé**

   **en ce que** l'optimisation d'ajustage comprend une optimisation de la fréquence moyenne, une optimisation de courants shims, une optimisation de la mise à l'échelle de transmission, une optimisation d'une transmission à plusieurs canaux, une optimisation d'une compensation de courant de Foucault et/ou

une optimisation de compensation de composantes transversales des champs de gradients et/ou

une optimisation d'une correction de non linéarité des champs de gradients.

8. Procédé suivant l'une des revendications précédentes, **caractérisé en ce qu'**une distance entre deux éléments (1 à 8) de volume envisagés voisins est égale à une distance entre deux éléments (X1 à X4) de volume supplémentaires voisins et est égale à une distance entre un élément (X2 ; X3) de volume supplémentaire à un élément (1 ; 8) de volume envisagé voisin.

9. Procédé suivant l'une des revendications précédentes, **caractérisé**

    **en ce que** les éléments (1 à 8) de volume envisagés forment une pile d'éléments de volume,
    **en ce que** les éléments (X1 à X4) de volume supplémentaires sont séparés en deux ensembles le plus possible égaux,
    **en ce que** l'on met l'un des ensembles (X1, X2) avant la pile (1 à 8) d'éléments de volume et l'autre des ensembles (X3, X4) après la pile (1 à 8) d'éléments de volume.

10. Procédé suivant l'une des revendications précédentes, **caractérisé**

    **en ce que** l'ensemble des éléments (1 à 8) de volume envisagés et l'ensemble des éléments (X1 à X4) de volume supplémentaires forment un ensemble total d'éléments (1 à 8, X1 à X4) de volume,
    **en ce que**, lors de la saisie des données RM, on effectue un passage au moins une fois,
    **en ce que**, dans le passage, on saisit des données RM pour chaque élément de volume de l'ensemble (1 à 8, X1 à X4) total,
    dans lequel on saisit en même temps respectivement des données RM d'au moins deux éléments de volume de l'ensemble (1 à 8, X1 à X4) total, et
    **en ce qu'**une distance entre des éléments (X1, 5 ; X2, 6 ; 1, 7) de volume voisins, dont on a saisit respectivement des données RM en même temps est constante.

11. Installation (10) de résonnance magnétique, qui comprend une unité (14) de commande HF, une unité (15) de commande de gradients et une commande (16) de séquence d'image, qui sont constituées pour saisir des données RM d'une partie en volume d'un objet à examiner, dans laquelle l'installation (10) de résonnance magnétique est constituée,

pour saisir des données RM de chaque élément de volume d'un ensemble donné à l'avance d'éléments (1 à 8) de volume envisagés dans la partie en volume,

pour déterminer un ensemble d'éléments (X1 à X4) de volume supplémentaires à l'extérieur de la partie en volume en fonction des éléments (1 à 8) de volume envisagés et de conditions (TR, T), et pour saisir en même temps des données RM d'au moins deux éléments (X1, 5 ; X2, 6 ; 3, X3 ; 4, X4) de volume, qui comprennent un élément (3 à 6) de volume de l'ensemble des éléments (1 à 8) de volume envisagés et un élément (X1 à X4) de volume de l'ensemble des éléments (X1 à X4) de volume supplémentaires, l'installation (10) de résonnance magnétique étant conformée pour effectuer le procédé suivant l'une des revendications 1 à 10.

12. Produit de programme d'ordinateur, qui comprend un programme et qui peut être chargé directement dans une mémoire d'un dispositif (10) de commande programmable d'une installation (5) de résonnance magnétique, comprenant des moyens de programme pour effectuer tous les stades du procédé suivant l'une des revendications 1 à 10, lorsque le programme est réalisé dans le dispositif (10) de commande de l'installation (5) de résonnance magnétique.

13. Support de données, déchiffrable électroniquement, sur lequel sont mises en mémoire des informations de commande déchiffrables électroniquement, qui sont conformées de manière à ce qu'elles exécutent, lors de l'utilisation du support (21) de mémoire dans un dispositif (10) de commande d'une installation (5) de résonnance magnétique, le procédé suivant l'une des revendications 1 à 10.

FIG 1

FIG 2

FIG 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **WANG et al.** Phase-cycled simultaneous multislice balanced SSFP imaging with CAIPIRINHA for efficient banding reduction : Simultaneous Multislice for SSFP Banding Reduction. *Magn. Reason. Med,* 2016, vol. 76, 1764-1774
- **KENKEL et al.** Whole-Body Diffusion Imaging Applying Simultaneous Multi-Slice Excitation. *ROFO - Fortschritte auf dem Gebiet der Röntgenstrahlen und der bildgebenden Verfahren,* 2016, vol. 188, 381-388
- **XU et al.** Evaluation of slice accelerations using multiband echo planar imaging at 3T. *Neuroimage,* 2013, vol. 83, 991-1001
- **SOUZA et al.** *J. CAT,* 1988, vol. 12, 1026
- **FEINBERG et al.** *MRM,* 2002, vol. 48 (1
- **WU et al.** *Proc. ISMRM,* vol. 2009, 2768
- **LARKMAN et al.** *JMRI,* 2001, vol. 13, 313